(19) Europäisches Patentamt
European Patent Office
Office européen des brevets

(11) **EP 4 346 343 A1**

(12) **EUROPÄISCHE PATENTANMELDUNG**

(43) Veröffentlichungstag:
**03.04.2024   Patentblatt 2024/14**

(21) Anmeldenummer: **22198412.3**

(22) Anmeldetag: **28.09.2022**

(51) Internationale Patentklassifikation (IPC):
**H05K 5/02** *(2006.01)*     **H05K 7/14** *(2006.01)*
**H05K 5/00** *(2006.01)*

(52) Gemeinsame Patentklassifikation (CPC):
**H05K 5/0247; H05K 5/0069; H05K 7/1432**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siemens Aktiengesellschaft**
**80333 München (DE)**

(72) Erfinder:
• **Nährig, Matthias**
  **91334 Hemhofen (DE)**
• **Zeyß, Felix**
  **91052 Erlangen (DE)**

(74) Vertreter: **Siemens Patent Attorneys**
**Postfach 22 16 34**
**80506 München (DE)**

(54) **SUBSTRAT, LEISTUNGSMODUL, ELEKTRISCHES GERÄT UND VERFAHREN ZUR HERSTELLUNG EINES LEISTUNGSMODULS**

(57)    Die Erfindung betrifft u.a. ein Substrat (1) für ein Leistungsmodul, wobei das Substrat (1) bei einer Draufsicht im Wesentlichen rechteckig mit zwei, sich gegenüberliegenden langen Seiten (2A, 2B) und zwei, sich gegenüberliegenden kurzen Seiten (3A, 3B) ausgestaltet ist, und wobei das Substrat (1) mehrere Halbleiter (4) zur Wandlung einer dreiphasigen Wechselspannung (AC) in eine positive, eine mittlere und eine negative Gleichspannung (DC) bzw. zur Wandlung einer positiven, einer mittleren und einer negativen Gleichspannung (DC) in eine dreiphasige Wechselspannung (AC) aufweist.

Insbesondere um ein verbessertes Substrat bereitzustellen, wird vorgeschlagen, dass das Substrat weiterhin aufweist:
- drei an den langen Seiten (2A, 2B) angeordnete AC-Anschlüsse (AC1, AC2, AC3),
- einen an der ersten kurzen Seite (3A) angeordneten positiven DC-Anschluss (DCP),
- einen an der ersten kurzen Seite (3A) angeordneten ersten mittleren DC-Anschluss (DCM1),
- einen an der zweiten kurzen Seite (3B) angeordneten zweiten mittleren DC-Anschluss (DCM2) und
- einen an der zweiten kurzen Seite (3B) angeordneten negativen DC-Anschluss (DCN),

wobei der positive DC-Anschluss (DCP) näher an der ersten langen Seite (2A) angeordnet ist als der erste mittlere DC-Anschluss (DCM1), und
wobei der negative DC-Anschluss (DCN) näher an der zweiten langen Seite (2B) angeordnet ist als der zweite mittlere DC-Anschluss (DCM2).

FIG 1

EP 4 346 343 A1

**Beschreibung**

Die Erfindung betrifft ein Substrat für ein Leistungsmodul, wobei das Substrat bei einer Draufsicht im Wesentlichen rechteckig mit zwei, sich gegenüberliegenden langen Seiten und zwei, sich gegenüberliegenden kurzen Seiten ausgestaltet ist und wobei das Substrat mehrere Halbleiter zur Wandlung einer dreiphasigen Wechselspannung (AC) in eine positive, eine mittlere und eine negative Gleichspannung (DC) bzw. zur Wandlung einer positiven, einer mittleren und einer negativen Gleichspannung (DC) in eine dreiphasige Wechselspannung (AC) aufweist.

Weiterhin betrifft die Erfindung ein Leistungsmodul aufweisend zumindest ein derartiges Substrat.

Ferner betrifft die Erfindung ein elektrisches Gerät, insbesondere einen Umrichter, aufweisend zumindest ein derartiges Leistungsmodul.

Schließlich betrifft die Erfindung ein Verfahren zur Herstellung eines derartigen Leistungsmoduls.

Derartige Vorrichtungen bzw. ein derartiges Verfahren kommen in einer Vielzahl von Anwendungen in der Leistungselektronik zum Einsatz. Beispielsweise werden bei mehrphasigen Halbleitermodulen mit Halbbrückentopologie die Zwischenkreisanschlüsse symmetrisch zu beiden Seiten herausgeführt, um eine möglichst gleichmäßige Induktivität der einzelnen Phasen zu erreichen. Bei einer 3-Level-Topologie ist dies ebenfalls wünschenswert und verursacht damit weiteren Platzbedarf. Bei kleinen Gehäusegrößen ist dies aufgrund des limitierten Platzes für Anschlüsse unter Einhaltung der Luft- und Kriechstrecken nur schwer erreichbar. Alternativ können bspw. andere Gehäusetypen gewählt werden, die mehr Platz bereitstellen.

Aus der US8847328B1 ist Leistungshalbleitermodul mit vier Leistungsanschlüssen bekannt. Ein Bipolartransistor mit isolierter Gate-Elektrode, englisch "insulated-gate bipolar transistor" (IGBT), hat einen Kollektor, der mit dem ersten Leistungsanschluss verbunden ist, und einen Emitter, der mit dem dritten Leistungsanschluss gekoppelt ist. Eine antiparallele Diode ist parallel mit dem IGBT gekoppelt. Zwischen dem zweiten und dem vierten Leistungsanschluss ist eine Gleichspannungsverbindung angeschlossen. Der DC-Link kann zwei Dioden und zwei IGBTs umfassen, wobei die IGBTs in einer Konfiguration mit gemeinsamem Kollektor verbunden sind. Die ersten und zweiten Leistungsanschlüsse sind in einer ersten Linie entlang einer Seite des Moduls angeordnet, und die dritten und vierten Leistungsanschlüsse sind in einer zweiten Linie entlang der gegenüberliegenden Seite des Moduls angeordnet. Zwei identische Instanzen des Moduls können miteinander verbunden werden, um einen dreistufigen NPC-Phasenzweig mit niedrigen Streuinduktivitäten zu bilden, wobei der Phasenzweig zwei parallele Gleichstromverbindungen aufweist.

Eine Aufgabe der Erfindung ist es, ein verbessertes Substrat, ein entsprechendes Leistungsmodul, ein entsprechendes elektrisches Gerät sowie ein entsprechendes Verfahren zur Herstellung eines Leistungsmoduls bereitzustellen.

Eine Lösung der Aufgabe ergibt sich durch ein Substrat der eingangs genannten Art dadurch, dass das Substrat weiterhin drei an den langen Seiten angeordnete AC-Anschlüsse, einen an der ersten kurzen Seite angeordneten positiven DC-Anschluss, einen an der ersten kurzen Seite angeordneten ersten mittleren DC-Anschluss, einen an der zweiten kurzen Seite angeordneten zweiten mittleren DC-Anschluss und einen an der zweiten kurzen Seite angeordneten negativen DC-Anschluss aufweist, und wobei der positive DC-Anschluss näher an der ersten langen Seite angeordnet ist als der erste mittlere DC-Anschluss, und wobei der negative DC-Anschluss näher an der zweiten langen Seite angeordnet ist als der zweite mittlere DC-Anschluss.

Eine weitere Lösung der Aufgabe ergibt sich durch ein Leistungsmodul der eingangs genannten Art dadurch, dass das Leistungsmodul das vorgeschlagene Substrat sowie ein Modulgehäuse aufweist, welches das Substrat zumindest teilweise einhaust.

Eine zusätzliche Lösung der Aufgabe ergibt sich durch ein elektrisches Gerät der eingangs genannten Art dadurch, dass das Gerät zumindest einen ersten Zwischenkreiskondensator, welcher zwischen den mit dem positiven DC-Anschluss elektrisch verbundenen Modul-DC-Anschluss einerseits und die mit den mittleren DC-Anschlüssen elektrisch verbundenen Modul-DC-Anschlüsse andererseits geschaltet ist, und zumindest einen zweiten Zwischenkreiskondensator aufweist, welcher zwischen den mit dem negativen DC-Anschluss elektrisch verbundenen Modul-DC-Anschluss einerseits und die mit den mittleren DC-Anschlüssen elektrisch verbundenen Modul-DC-Anschlüsse andererseits geschaltet ist.

Schließlich ergibt sich eine Lösung der Aufgabe durch ein Verfahren zur Herstellung des vorgeschlagenen Leistungsmoduls dadurch, dass das Verfahren folgende Verfahrensschritte umfasst:

- Bereitstellen eines Ausgangs-Leistungsmoduls aufweisend:

  o zumindest zwei, an der ersten kurzen Seite angeordnete Ausgangs-Leistungsmodul-Spannungsanschlüsse,
  o zumindest zwei, an der zweiten kurzen Seite angeordnete Ausgangs-Leistungsmodul-Spannungsanschlüsse,
  o ein Ausgangs-Modulgehäuse zur Aufnahme und zum zumindest teilweisen Einhausen des Substrats, und

- Einbringen des Substrats in das Ausgangs-Leistungsmodul,

- Herstellen einer jeweiligen elektrischen Verbindung von den vier DC-Anschlüssen des Substrats mit den vier Ausgangs-Leistungsmodul-Spannungsanschlüssen.

Bei dem vorgeschlagenen Substrat kann es sich bspw. um ein DCB(Direct Copper Bonded)-Substrat oder um ein AMB(Active Metal Brazing)-Substrat handeln. In manchen Beispielen kann auch eine Leiterplatte (printed circuit board, PCB) als Substrat verwendet werden. Weiterhin kann das Substrat auch zweistückig oder mehrstückig ausgestaltet sein.

Bei einer Draufsicht ist das Substrat im Wesentlichen rechteckig ausgestaltet, wobei das Substrat als flache Platte bzw. als flacher Quader ausgestaltet sein kann. Ist das Substrat dabei zweistückig oder mehrstückig ausgestaltet, weist das aus den zwei oder mehr Substratstücken gebildete Substrat den bei einer Draufsicht im wesentlichen rechteckigen Grundriss auf.

Zur Wandlung der dreiphasigen Wechselspannung in drei unterschiedliche Gleichspannungen bzw. umgekehrt weist das Substrat mehrere Halbleiter auf, wie zum Beispiel Transistoren, welche z.B. als Leistungs-MOSFETs, IGBTs, etc. ausgestaltet sind, oder Dioden. Dabei sind die Halbleiter vorzugsweise Leistungs-Halbleiter und sind weiterhin passend, bspw. gemäß einer 3-Stufen-Ausführung, miteinander verschaltet und mit den AC-Anschlüssen und den DC-Anschlüssen elektrisch verbunden.

Dabei ist vorgesehen, dass die drei AC-Anschlüsse für die drei Phasen der Wechselspannung an den langen Seiten des im Wesentlichen rechteckigen Substrats angeordnet sind. Bemerkenswerterweise sind vier DC-Anschlüsse für die drei unterschiedlichen Gleichspannungen vorgesehen, nämlich ein positiver DC-Anschluss für eine positive Gleichspannung, zwei mittlere DC-Anschlüsse für eine mittlere bzw. neutrale Gleichspannung und ein negativer DC-Anschluss für eine negative Gleichspannung. Dabei sind die vier DC-Anschlüsse wie folgt an den kurzen Seiten des im Wesentlichen rechteckigen Substrats angeordnet. Der positive DC-Anschluss und der erste mittlere DC-Anschluss sind an der ersten kurzen Seite des im Wesentlichen rechteckigen Substrats angeordnet, wobei der positive DC-Anschluss dabei näher an der ersten langen Seite des im Wesentlichen rechteckigen Substrats angeordnet ist als der erste mittlere DC-Anschluss. Der zweite mittlere DC-Anschluss und der negative DC-Anschluss sind an der zweiten kurzen Seite des im Wesentlichen rechteckigen Substrats angeordnet, wobei der negative DC-Anschluss dabei näher an der zweiten langen Seite des im Wesentlichen rechteckigen Substrats angeordnet ist als der zweite mittlere DC-Anschluss.

Zur Veranschaulichung nehmen wir an, dass das Substrat in einer Draufsicht betrachtet wird und das Substrat so ausgerichtet ist, dass die langen Seiten oben und unten und die kurzen Seiten des Substrats rechts und links angeordnet sind. Dann sind die AC-Anschlüsse oben und/oder unten angeordnet, der positive DC-Anschluss ist links oben, der erste mittlere DC-Anschluss ist links unten, der zweite mittlere DC-Anschluss ist rechts oben und der negative DC-Anschluss ist rechts unten angeordnet.

Die erläuterte Ausgestaltung des Substrats, insbesondere die besondere Anordnung der AC-Anschlüsse und der DC-Anschlüsse, bewirkt dabei eine vergleichsmäßig gleichmäßige Verteilung der Impedanzen bzw. Induktivitäten, insbesondere unter den drei Wechselspannungs-Phasen in dem Substrat. Die vergleichsmäßig gleichmäßige Verteilung der Impedanzen wird unter anderem auch dadurch erreicht, dass die Impedanzen der einzelnen Wechselspannungs-Phasen dank der Anordnung der DC-Anschlüsse vergleichsweise symmetrisch ausgestaltet sind. Damit ergibt sich während des Betriebs des Substrats bzw. des entsprechenden Leistungsmoduls eine vergleichsweise gleichmäßige Belastung der einzelnen Wechselspannungs-Phasen, was von großem Vorteil ist. Denn ungleich belastete Wechselspannungs-Phasen verursachen während des Betriebs des Substrats bzw. des vorgeschlagenen Leistungsmoduls eine besonders starke Erwärmung einer der Wechselspannungs-Phasen, was die Lebensdauer der Bauteile dieser Wechselspannungs-Phase und somit die Lebensdauer des Substrats und des Leistungsmoduls beeinträchtigt. Außerdem kann es notwendig sein, der erläuterten, stärkeren Erwärmung einer der Wechselspannungs-Phasen durch zusätzlichen Kühlaufwand, bspw. größere Kühlkörper und dergleichen, baulich entgegenzuwirken, was größere Kosten verursacht und manchmal mehr Bauchraum erfordert und somit in einem räumlich größeren Leistungsmodul resultiert, ohne dass damit eine größere elektrische Leistung einhergeht.

Weiterhin ermöglicht die erläuterte Ausgestaltung des Substrats, dass bewährte Gehäusetypen als Modulgehäuse genutzt werden können. Zusätzlich erlaubt insbesondere die erläuterte Anordnung der DC-Anschlüsse, Kondensatoren nahe dem jeweils relevanten Potential zu platzieren, insb. näher als 20% oder 10% der Diagonale des Substrats bei einer Draufsicht auf das Substrat. Damit werden bspw. keine neuen Modultypen bzw. Gehäusetypen benötigt, welche entweder größer sind oder neue Fertigungstechnologien benötigen. Weiterhin wird es dadurch leichter, Plattformen in den Gerätereihen zu verwirklichen.

Bei einer vorteilhaften Ausgestaltung der Erfindung sind die drei AC-Anschlüsse an einer der beiden langen Seiten angeordnet, vorzugsweise an der ersten langen Seite.

Dies bedeutet, dass alle drei AC-Anschlüsse an derselben langen Seite angeordnet sind, wodurch insb. eine symmetrische Ausgestaltung der Anordnung erleichtert wird. Die drei AC-Anschlüsse können dabei bspw. an der ersten langen Seite (in dem obigen Beispiel zur Veranschaulichung also oben) oder an der zweiten langen Seite (in dem obigen Beispiel zur Veranschaulichung also unten) angeordnet sein, wobei die DC-Anschlüsse aus Symmetriegründen wie oben bereits erläutert angeordnet sein können oder punktsymmetrisch bezüglich der Mitte des Substrats gespiegelt angeordnet sein können (im obigen Beispiel zur Veranschaulichung also wie folgt: der positive DC-Anschluss ist links oben, der erste mittlere DC-Anschluss ist links unten, der zweite mittlere DC-Anschluss ist rechts oben und der negative DC-Anschluss ist rechts unten angeordnet; bzw. bei einer punktgespiegelten Anordnung wie folgt: der negative DC-Anschluss ist links oben, der zweite mittlere DC-Anschluss ist links unten, der erste mittlere DC-Anschluss ist rechts oben und der positive DC-Anschluss ist rechts unten angeordnet).

Bei einer weiteren vorteilhaften Ausgestaltung der Erfindung ist das Substrat derart ausgestaltet, dass die Impedanzen zwischen den DC-Anschlüssen zweier der Gleichspannungen für die drei Phasen der Wechselspannung innerhalb einer tolerierbaren Abweichung gleich sind, wobei die tolerierbare Abweichung 25%, insbesondere 15% oder 10%, beträgt.

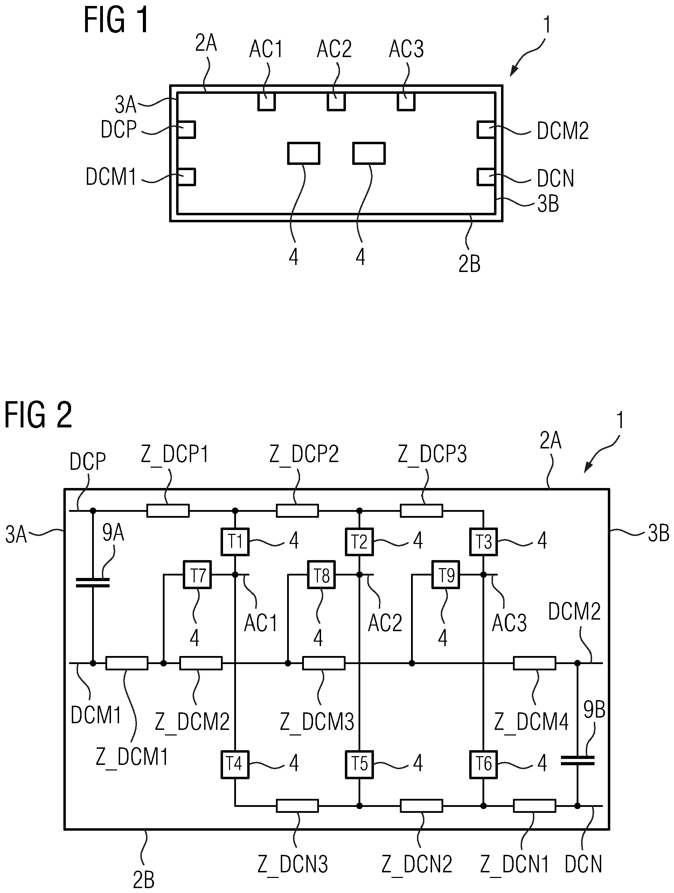

Beispielsweise ist also die Impedanz, also der Wechselstromwiderstand, zwischen dem positiven DC-Anschluss und dem negativen DC-Anschluss für die drei Phasen der Wechselspannung innerhalb der tolerierbaren Abweichung gleich. Damit ist insbesondere gemeint, dass die Impedanz zwischen dem positiven DC-Anschluss und dem negativen DC-Anschluss entlang der ersten Phase der dreiphasigen Wechselspannung innerhalb der tolerierbaren Abweichung gleich ist mit der Impedanz zwischen dem positiven DC-Anschluss und dem negativen DC-Anschluss entlang der zweiten Phase der dreiphasigen Wechselspannung, welche beide wiederum innerhalb der tolerierbaren Abweichung gleich sind mit der Impedanz zwischen dem positiven DC-Anschluss und dem negativen DC-Anschluss entlang der dritten Phase der dreiphasigen Wechselspannung. Gleiches gilt für die Impedanzen zwischen dem positiven DC-Anschluss und den beiden DC-Anschlüssen der mittleren/neutralen Gleichspannung sowie für die Impedanzen zwischen dem negativen DC-Anschluss und den beiden DC-Anschlüssen der mittleren/neutralen Gleichspannung. Dabei sind die genannten Impedanzen insbesondere bei der Betriebsfrequenz des Substrats, bzw. der Halbleiter innerhalb der tolerierbaren Abweichung gleich. Sind die Halbleiter als Transistoren ausgestaltet, so sind die genannten Impedanzen insbesondere bei der Schalt- bzw. Taktfrequenz der Transistoren innerhalb der tolerierbaren Abweichung gleich. In einigen Beispielen kann die entsprechende Induktivität zwischen den DC-Anschlüssen zweier der Gleichspannungen für die drei Phasen der Wechselspannung innerhalb der tolerierbaren Abweichung gleich sein. Weitere Details zu diesem Aspekt werden im Zusammenhang mit der Figur 2 weiter unten erläutert.

Die tolerierbare Abweichung liegt dabei im Bereich von bis zu 25%, vorzugsweise bis zu 15% oder bis zu 10%.

Um die genannten Impedanzen innerhalb der tolerierbaren Abweichung gleich auszugestalten, kann das Substrat bspw. symmetrisch bzw. annähernd symmetrisch ausgestaltet sein. Die symmetrische Ausgestaltung des Substrats kann bspw. umfassen, dass die drei AC-Anschlüsse in etwa äquidistant zueinander und dabei in etwa in der Mitte zwischen den beiden kurzen Seiten angeordnet sind. Vorzugsweise sind die drei AC-Anschlüsse recht nahe, insb. näher als 20% oder 10% der Diagonale des Substrats bei einer Draufsicht auf das Substrat, beieinander angeordnet. Weiterhin können die elektrische Leiter bzw. Leiterbahnen, welche die AC-Anschlüsse mit den Halbleitern bzw. die Halbleiter mit den DC-Anschlüssen verbinden, in etwa symmetrisch ausgestaltet werden bzw. in etwa mit gleichen Querschnitten und in etwa mit gleichen Induktivitäten ausgestaltet werden. Insbesondere können die Impedanzen der genannten elektrischen Leitern bzw. Leiterbahnen vorab berechnet bzw. simuliert werden und derart angepasst bzw. aufeinander abgestimmt werden, dass die gewünschten Impedanzen erzielt werden. Die genannte Anpassung bzw. Abstimmung kann bspw. dadurch erreicht werden, dass die Leiter bzw. Leiterbahnen mit einem größeren oder einem kleineren Querschnitt als ursprünglich bzw. sonst geplant ausgeführt werden oder auf dem Substrat anders als die kürzest mögliche Verbindung geführt werden, um die Induktivität bzw. Impedanz der genannten Leiter bzw. Leiterbahnen untereinander möglichst gut abzustimmen.

Bei einer weiteren vorteilhaften Ausgestaltung der Erfindung ist das Substrat derart ausgestaltet, dass die Impedanzen zwischen dem positiven DC-Anschluss und den beiden mittleren DC-Anschlüssen für die drei Phasen der Wechselspannung innerhalb der tolerierbaren Abweichung gleich sind und weiterhin innerhalb der tolerierbaren Abweichung gleich den Impedanzen zwischen dem negativen DC-Anschluss und den beiden mittleren DC-Anschlüssen für die drei Phasen der Wechselspannung sind.

Wie oben schon erwähnt, sind auch die Impedanzen zwischen dem positiven DC-Anschluss und den beiden DC-Anschlüssen der mittleren/neutralen Gleichspannung innerhalb der tolerierbaren Abweichung gleich zueinander, wobei auch die Impedanzen zwischen dem negativen DC-Anschluss und den beiden DC-Anschlüssen der mittleren/neutralen Gleichspannung innerhalb der tolerierbaren Abweichung gleich zueinander sind. Aus Symmetriegründen und insbesondere um eine möglichst gleichmäßige Belastung der einzelnen Wechselspannungs-Phasen während des Betriebs des Substrats bzw. des Leistungsmoduls zu erreichen, sind nunmehr weiterhin die Impedanzen zwischen dem positiven DC-Anschluss und den beiden DC-Anschlüssen der mittleren/neutralen Gleichspannung innerhalb der tolerierbaren Abweichung gleich mit den Impedanzen zwischen dem negativen DC-Anschluss und den beiden DC-Anschlüssen der mittleren/neutralen Gleichspannung, wobei jeweils die drei Phasen der Wechselspannung berücksichtigt werden. Weitere Details zu diesem Aspekt werden im Zusammenhang mit der Figur 2 weiter unten erläutert.

Wie oben bereits erwähnt, weist das vorgeschlagene Leistungsmodul ein Modulgehäuse auf, welches bspw. teils rahmenförmig ausgestaltet sein und welches das Substrat in seiner Mitte aufnehmen und dabei fixieren. Neben einem rahmenförmigen Gehäuseteil kann das Modulgehäuse noch eine Abdeckung aufweisen, welche unter anderem dazu dienen kann, das Substrat vor Umwelteinflüssen zu schützen und Gefährdungen aufgrund der während des Betriebs des Leistungsmoduls auftretenden Spannungen zu verhindern. In manchen Beispielen weist das Modulgehäuse dabei mehrere Ausnehmungen zur Aufnahme von Anschlusspins auf. Dann können die drei AC-Anschlüsse und die vier DC-Anschlüsse des Substrats jeweils mit zumindest einem Anschlusspin elektrisch verbunden sein, wobei der jeweilige Anschlusspin in einer der Ausnehmungen das Modulgehäuses untergebracht ist.

Bei einer weiteren vorteilhaften Ausgestaltung der Erfindung weist das Leistungsmodul drei an den langen Seiten angeordnete Modul-AC-Anschlüsse, die mit den drei AC-Anschlüssen des Substrats elektrisch verbunden sind, und vier an den kurzen Seiten angeordnete Modul-DC-Anschlüsse auf, die mit den vier DC-Anschlüssen des Substrats elektrisch verbunden sind. Die jeweilige elektrische Verbindung kann beispielsweise über die oben genannten Anschlusspins erfolgen, wenn das Modulgehäuse diese aufweist.

Damit das Leistungsmodul mit der dreiphasigen Wechselspannung bzw. den drei genannten Gleichspannungen versorgt werden kann bzw. damit an dem Leistungsmodul die dreiphasige Wechselspannung bzw. die drei genannten Gleichspannungen abgegriffen werden können, weist das Leistungsmodul drei Modul-AC-Anschlüsse und vier Modul-DC-Anschlüsse auf. Dabei sind die drei AC-Anschlüsse des Substrats mit den drei Modul-AC-Anschlüssen elektrisch verbunden, und die vier DC-Anschlüsse des Substrats sind mit den vier Modul-DC-Anschlüssen elektrisch verbunden. Wie auch die drei AC-Anschlüsse des Substrats, sind auch die drei Modul-AC-Anschlüsse an den langen Seiten angeordnet, wobei die vier Modul-DC-Anschlüsse - wie auch die DC-Anschlüsse des Substrats - an den kurzen Seiten angeordnet sind. Diese Ausgestaltung des Leistungsmoduls ermöglicht eine kurze und direkte elektrische Verbindung der Modul-AC-Anschlüsse bzw. der Modul-DC-Anschlüsse mit den entsprechenden AC-Anschlüssen bzw. DC-Anschlüssen des Substrats, wobei die genannte elektrische Verbindung bei manchen Beispielen über die passenden Anschlusspins erfolgt.

Bei einer weiteren vorteilhaften Ausgestaltung der Erfindung sind der mit dem positiven DC-Anschluss elektrisch verbundene Modul-DC-Anschluss und der mit dem ersten mittleren DC-Anschluss elektrisch verbundene Modul-DC-Anschluss an der ersten kurzen Seite angeordnet, wobei der mit dem positiven DC-Anschluss elektrisch verbundene Modul-DC-Anschluss näher an der ersten langen Seite angeordnet ist als der mit dem ersten mittleren DC-Anschluss elektrisch verbundene Modul-DC-Anschluss, wobei der mit dem negativen DC-Anschluss elektrisch verbundene Modul-DC-Anschluss und der mit dem zweiten mittleren DC-Anschluss elektrisch verbundene Modul-DC-Anschluss an der zweiten kurzen Seite angeordnet sind, wobei der mit dem negativen DC-Anschluss elektrisch verbundene Modul-DC-Anschluss näher an der zweiten langen Seite angeordnet ist als der mit dem zweiten mittleren DC-Anschluss elektrisch verbundene Modul-DC-Anschluss.

Die erläuterte Ausgestaltung und insbesondere die erläuterte Anordnung der Modul-AC-Anschlüsse sowie der Modul-DC-Anschlüsse ermöglicht eine besonders kurze und direkte elektrische Verbindung mit den entsprechenden AC-Anschlüssen bzw. DC-Anschlüssen des Substrats. Dadurch können die während des Betriebs auftretenden elektrischen Verluste, aber auch unerwünschte Induktivitäten weiter verringert werden, wobei gleichzeitig die oben erwähnte gleichmäßige Belastung der einzelnen Wechselspannungs-Phasen unterstützt wird.

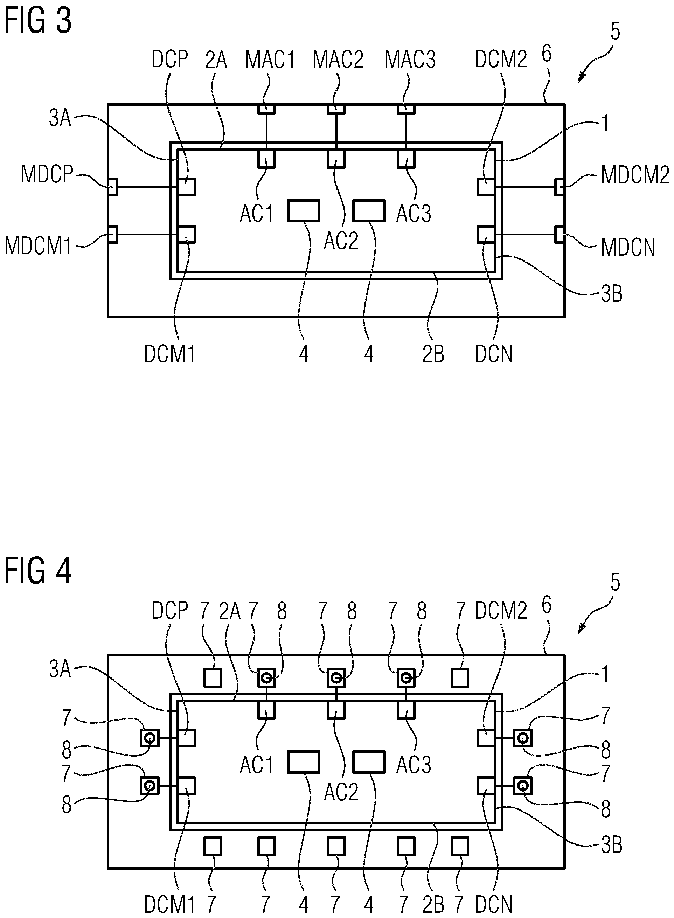

Konkrete Ausgestaltungen dieses Aspekts werden im Zusammenhang mit den Figuren 4 bis 7 weiter unten erläutert.

Bei einer weiteren vorteilhaften Ausgestaltung der Erfindung weist das Leistungsmodul weiterhin einen ersten Stützkondensator, welcher zwischen die positive Gleichspannung am positiven DC-Anschluss und die mittlere Gleichspannung am ersten mittleren DC-Anschluss geschaltet ist, und einen zweiten Stützkondensator auf, welcher zwischen die negative Gleichspannung am negativen DC-Anschluss und die mittlere Gleichspannung am zweiten mittleren DC-Anschluss geschaltet ist.

Als Stützkondensator oder auch Entkopplungskondensator wird dabei der Einsatz eines Kondensators zur Stabilisierung der Versorgungsspannung in hochfrequenten und komplexen digitalen Schaltungen verstanden. In der Funktion ist der Stützkondensator einem Glättungskondensator ähnlich. Hier werden zu jedem Schaltkreis oder Schaltungsabschnitt ein oder mehrere Kondensatoren parallel zur Versorgungsspannung geschaltet, die als Spannungs- oder Energiequelle in Momenten hohen Strom- bzw. Leistungsbedarfs wirken. Durch ihre niedrige Impedanz bei hohen Frequenzen verringern sie die Impedanz der übergeordneten Spannungsversorgung oder deren Zuleitung und verhindern eine gegenseitige Beeinflussung der Energieversorgung von Teilschaltungen. Auf den Ausgangs-Signalleitungen vermindern sie sowohl "Überschwinger" als auch "Unterschwinger" der Signalpegel und damit die Möglichkeit von Störungen in der Signalverarbeitung. Umgekehrt können Kondensatoren störende, zeitlich begrenzte Überspannungen in elektronischen Schaltungen aufnehmen und so ihre Ausbreitung und schädliche Wirkung vermindern.

Die erläuterte, insbesondere symmetrische Anordnung der DC-Anschlüsse bzw. Modul-DC-Anschlüsse ermöglicht insbesondere eine gute Platzierung von Stützkondensatoren für die relevanten Kommutierungszweige außerhalb des Moduls. Insbesondere kann der jeweilige Stützkondensator räumlich sehr nahe, insb. näher als 20% oder 10% der Diagonale des Substrats bei einer Draufsicht auf das Substrat, an den genannten DC-Anschlüssen angeordnet werden, wodurch während des Betriebs auftretende elektrische Verluste, aber auch unerwünschte Induktivitäten weiter verringert werden können. Vorzugsweise hat die elektrische Verbindung des jeweiligen Stützkondensators mit dem jeweiligen DC-Anschluss eine Länge von höchstens 20% oder 10% der Diagonale des Substrats bei einer Draufsicht auf das Substrat.

Bei einer weiteren vorteilhaften Ausgestaltung der Erfindung weist das Leistungsmodul dabei weiterhin eine Leiterplatte auf, wobei der erste Stützkondensator und der zweite Stützkondensator jeweils auf der Leiterplatte angeordnet sind.

Die genannte Leiterplatte kann bspw. als Platine (Englisch: printed circuit board, PCB) aber auch als weiteres DCB-Substrat oder weiteres AMB-Substrat oder dergleichen ausgeführt sein. Vorzugsweise ist die Leiterplatte dabei in räumlicher Nähe zu dem Substrat angeordnet, um kurze elektrische Verbindungen des jeweiligen Stützkondensators mit dem jeweiligen DC-Anschluss zu gewährleisten.

Bei einer weiteren vorteilhaften Ausgestaltung der Erfindung sind der erste Stützkondensator und der zweite Stützkondensator jeweils auf dem Substrat angeordnet.

Besonders kurze elektrische Verbindungen des jeweiligen Stützkondensators mit dem jeweiligen DC-Anschluss können insbesondere dadurch erreicht werden, dass der jeweilige Stützkondensator auf dem Substrat angeordnet ist und passend mit dem jeweiligen DC-Anschluss elektrisch verbunden ist. Vorzugsweise ist der erste Stützkondensator in der Gegend der ersten kurzen Seite und der zweite Stützkondensator in der Gegend der zweiten kurzen Seite angeordnet, wobei der Abstand des jeweiligen Stützkondensators von der jeweiligen kurzen Seite insb. höchstens 20% oder 10% der Diagonale des Substrats bei einer Draufsicht auf das Substrat beträgt.

Bei einer weiteren vorteilhaften Ausgestaltung der Erfindung ist das Leistungsmodul mit einer elektrischen Leistung von zumindest mehreren 10 kW, vorzugsweise 40 kW bis 500 kW, mit einer Wechselspannung von zumindest mehreren 100 V, vorzugsweise 280 V bis 800 V, mit einer Gleichspannung von zumindest mehreren 100 V, vorzugsweise 800 V bis 1500 V, und/oder elektrischen Strömen von mehreren 10 A, vorzugsweise 70 A bis 1000 A, betreibbar.

Wie oben bereits erwähnt, weist das vorgeschlagene elektrische Gerät zumindest ein Leistungsmodul, zumindest einen ersten Zwischenkreiskondensator und zumindest einen zweiten Zwischenkreiskondensator auf.

Bei einigen abgewandelten Beispielen kann das elektrische Gerät als Gleichrichter zum Gleichrichten einer dreiphasigen Wechselspannung in die drei Gleichspannungen ausgestaltet sein, wofür das elektrische Gerät bspw. lediglich ein passend elektrisch verschaltetes Leistungsmodul aufweist. In anderen abgewandelten Beispielen kann das elektrische Gerät als Wechselrichter zum Wechselrichten der drei Gleichspannungen in eine dreiphasige Wechselspannung ausgestaltet sein, wofür das elektrische Gerät bspw. lediglich ein passend elektrisch verschaltetes Leistungsmodul aufweist. Weist das elektrische Gerät sowohl einen Gleichrichter als auch einen Wechselrichter auf, kann das elektrische Gerät als Umrichter zum Umrichten einer dreiphasigen Wechselspannung in eine andere dreiphasige Wechselspannung ausgestaltet sein.

Bei dem vorgeschlagenen Verfahren ist von besonderem Vorteil, dass handelsübliche Ausgangs-Leistungsmodule bzw. zumindest deren Ausgangs-Modulgehäuse verwendet werden können, welche günstig und in großer Stückzahl verfügbar sind. Beispielsweise können die IGBT-Module "EconoDual3" von Infineon Technologies AG, München, "SEMiX" von SEMIKRON Elektronik GmbH & Co. KG, Nürnberg oder "SD3" von Siemens AG, München bzw. deren Modulgehäuse als Ausgangs-Leistungsmodul bzw. Ausgangs-Modulgehäuse dienen. Diese IGBT-Module werden speziell für Anwendungen in 2-Level-Technologie genutzt, um z.B. eine einzelne Halbbrücke aus mehreren einzelnen IGBT-Halbleitern zu realisieren.

Gemäß dem vorgeschlagenen Verfahren sind dabei insb. keine teuren Spezialanpassungen erforderlich, welche teils aufgrund geringer, zu erwartender Stückzahlen schwerlich am Markt verfügbar sind. Insbesondere kann bei dem Ausgangs-Leistungsmodul bzw. dem Ausgangs-Modulgehäuse eine herkömmliche Leiterplatte bzw. ein herkömmliches Substrat verzichtet werden, da das Ausgangs-Leistungsmodul bzw. das Ausgangs-Modulgehäuse mit dem vorgeschlagenen Substrat ausgestattet und damit ertüchtigen wird.

Dazu wird das weiter oben bereits erläuterte Ausgangs-Leistungsmodul bzw. Ausgangs-Modulgehäuse mit dem vorgeschlagenen Substrat ausgerüstet. Anschließend werden die vier DC-Anschlüsse des Substrats passend mit den vier Ausgangs-Leistungsmodul-Spannungsanschlüssen elektrisch verbunden.

Bei einer weiteren vorteilhaften Ausgestaltung der Erfindung werden der positive DC-Anschluss und der erste mittlere DC-Anschluss mit den beiden, an der ersten kurzen Seite angeordneten Ausgangs-Leistungsmodul-Spannungsanschlüssen elektrisch verbunden, wobei der mit dem positiven DC-Anschluss elektrisch verbundene Ausgangs-Leistungsmodul-Spannungsanschluss näher an der ersten langen Seite angeordnet ist als der mit dem ersten mittleren DC-Anschluss elektrisch verbundene Ausgangs-Leistungsmodul-Spannungsanschluss, wobei der negative DC-Anschluss und der zweite mittlere DC-Anschluss mit den beiden, an der zweiten kurzen Seite angeordneten Ausgangs-Leistungsmodul-Spannungsanschlüssen elektrisch verbunden werden, und wobei der mit dem negativen DC-Anschluss elektrisch verbundene Ausgangs-Leistungsmodul-Spannungsanschluss näher an der zweiten langen Seite angeordnet ist als der mit dem zweiten mittleren DC-Anschluss elektrisch verbundene Ausgangs-Leistungsmodul-Spannungsanschluss.

Vorzugsweise ist dabei der jeweilige der vier Ausgangs-Leistungsmodul-Spannungsanschlüsse und der jeweilige der vier DC-Anschlüsse des Substrats an derselben kurzen Seite angeordnet, wodurch kurze elektrische Verbindungen zwischen den passenden, genannten Anschlüssen erreicht werden können, wobei die jeweilige elektrische Verbindung vorzugsweise kürzer als 20% oder 10% der Diagonale des Substrats bei einer Draufsicht auf das Substrat ist.

Bei einer weiteren vorteilhaften Ausgestaltung der Erfindung werden weiterhin drei, an den langen Seiten des Ausgangs-Leistungsmoduls angeordnete Modul-AC-Anschlüsse bereitgestellt, und es wird eine jeweilige elektrische Verbindung von den drei AC-Anschlüssen des Substrats mit den drei Modul-AC-Anschlüssen hergestellt. Vorzugsweise sind dabei die drei Modul-AC-Anschlüsse und die drei AC-Anschlüsse des Substrats an derselben langen Seite angeordnet, wodurch kurze elektrische Verbindungen zwischen den passenden, genannten Anschlüssen erreicht werden können, wobei die jeweilige elektrische Verbindung vorzugsweise kürzer als 20% oder 10% der Diagonale des Substrats bei einer Draufsicht auf das Substrat ist.

Im Folgenden wird die Erfindung anhand der in den Figuren dargestellten Ausführungsbeispiele näher beschrieben und erläutert. Es zeigen:

FIG 1        ein erstes Ausführungsbeispiel des vorgeschlagenen Substrats,
FIG 2        ein Schaltbild eines zweiten Ausführungsbeispiels des vorgeschlagenen Substrats,
FIGs 3-8     ein erstes bis sechstes Ausführungsbeispiel des vorgeschlagenen Leistungsmoduls,
FIG 9        ein Ausführungsbeispiel des vorgeschlagenen elektrischen Geräts und
FIG 10       ein Ablaufschema eines Ausführungsbeispiels des vorgeschlagenen Verfahrens zur Herstellung eines Ausführungsbeispiels eines Leistungsmoduls.

Die Figur 1 zeigt ein erstes Ausführungsbeispiel des vorgeschlagenen Substrats 1, wobei eine schematische Draufsicht dargestellt ist.

Das Substrat 1 ist bei der dargestellten Draufsicht im Wesentlichen rechteckig und weist somit mit zwei, sich gegenüberliegende lange Seiten 2A und 2B sowie zwei, sich gegenüberliegende kurze Seiten 3A, 3B auf. Weiterhin weist das Substrat 1 mehrere Halbleiter 4 auf, wobei in Figur 1 der Übersichtlichkeit halber nur zwei Halbleiter 4 dargestellt sind. Die Halbleiter 4 dienen dabei zur Wandlung einer dreiphasigen Wechselspannung (AC) in eine positive, eine mittlere und eine negative Gleichspannung (DC) bzw. zur Wandlung einer positiven, einer mittleren und einer negativen Gleichspannung (DC) in eine dreiphasige Wechselspannung (AC).

An den langen Seiten 2A, 2B weist das Substrat 1 drei AC-Anschlüsse AC1, AC2, AC3 zum Beaufschlagen des Substrats 1 bzw. Abgreifen von dem Substrat 1 der dreiphasigen Wechselspannung (AC) auf. Dabei sind die drei AC-Anschlüsse AC1, AC2, AC3 vorzugsweise an einer der beiden langen Seiten 2A, 2B angeordnet, bspw. wie in Figur 1 dargestellt an der ersten langen Seite 2A. An der ersten kurzen Seite 3A weist das Substrat 1 einen positiven DC-Anschluss DCP zum Beaufschlagen des Substrats 1 bzw. Abgreifen von dem Substrat 1 einer positiven Gleichspannung auf. Weiterhin weist das Substrat 1 an der ersten kurzen Seite 3A einen ersten mittleren DC-Anschluss DCM1 zum Beaufschlagen des Substrats 1 bzw. Abgreifen von dem Substrat 1 einer mittleren bzw. neutralen Gleichspannung auf. Dabei ist der positive DC-Anschluss DCP näher an der ersten langen Seite 2A angeordnet als der erste mittlere DC-Anschluss DCM1.

An der zweiten kurzen Seite 3B weist das Substrat 1 einen negativen DC-Anschluss DCN zum Beaufschlagen des Substrats 1 bzw. Abgreifen von dem Substrat 1 einer negativen Gleichspannung auf. Weiterhin weist das Substrat 1 an der zweiten kurzen Seite 3B einen zweiten mittleren DC-Anschluss DCM2 zum Beaufschlagen des Substrats 1 bzw. Abgreifen von dem Substrat 1 der mittleren bzw. neutralen Gleichspannung auf. Dabei ist der negative DC-Anschluss DCN näher an der zweiten langen Seite 2B angeordnet als der zweite mittlere DC-Anschluss DCM2.

Zur erwähnten Spannungswandlung sind die Halbleiter 4 passend miteinander verschaltet und mit den AC-Anschlüssen AC1, AC2, AC3 und den DC-Anschlüssen DCP, DCM1, DCM2, DCP elektrisch verbunden, was in Figur 1 der Übersichtlichkeit halber nicht näher dargestellt ist, jedoch in Figur 2 beispielhaft dargestellt ist.

Die Figur 2 zeigt ein Schaltbild eines zweiten Ausführungsbeispiels des vorgeschlagenen Substrats 1, wobei gleiche Bezugszeichen wie in Figur 1 dabei gleiche Gegenstände bezeichnen.

Im Unterschied zum ersten Ausführungsbeispiel weist das Substrat 1 gemäß dem zweiten Ausführungsbeispiel einen ersten Stützkondensator 9A und einem zweiten Stützkondensator 9B auf. Dabei ist der erste Stützkondensator 9A zwischen der positiven Gleichspannung am positiven DC-Anschluss DCP und der mittleren Gleichspannung am ersten mittleren DC-Anschluss DCM1 geschaltet. Der zweite Stützkondensator 9B ist zwischen der negativen Gleichspannung am negativen DC-Anschluss DCN und der mittleren Gleichspannung am zweite mittleren DC-Anschluss DCM2 geschaltet. Alternativ können der erste Stützkondensator 9A und der zweite Stützkondensator 9B auch außerhalb des Substrats 1 in dem Leistungsmodul 5 angeordnet sein, bspw. auf einer Leiterplatte 10, welche von dem Leistungsmodul umfasst ist.

Das Substrat 1 weist insgesamt neun Halbleiter 4 auf, welche mit T1, T2, ..., T9 durchnummeriert sind. Dabei ist zwischen dem jeweiligen AC-Anschluss AC1, AC2 oder AC3 je ein Halbleiter 4 zum positiven DC-Anschluss DCP, zu den beiden mittleren DC-Anschlüssen DCM1 und DCM2 sowie zu dem negativen DC-Anschluss DCN angeordnet, wobei diese Anordnung die oben erwähnte Spannungswandlung erlaubt.

Weiterhin weist das Substrat 1 insgesamt zehn Impedanzen Z auf, wobei hierfür in Figur 2 die Notation Z_DCXY verwendet wird und dabei X für das Gleichspannungspotenzial (d. h. positive, mittlere/neutrale oder negative Gleichspannung DCP, DCM, DCN) steht und Y für jedes Gleichspannungspotenzial durchnummeriert wird.

Vorteilhafterweise ist Substrat 1 dabei derart ausgestaltet, dass die Impedanzen Z zwischen den DC-Anschlüssen DCP, DCM1, DCM2, DCN zweier der Gleichspannungen für die drei Phasen der Wechselspannung innerhalb einer tolerierbaren Abweichung gleich sind, wobei die tolerierbare Abweichung 25%, insbesondere 15% oder 10%, beträgt.

In diesem Beispiel sind somit also die Impedanzen zwischen dem positiven DC-Anschluss DCP und dem negativen DC-Anschluss DCN für die drei Phasen der Wechselspannung innerhalb der tolerierbaren Abweichung gleich, d.h. also wegen einer Reihenschaltung der Einzel-Impedanzen:

- Für die erste Wechselspannungsphase (angeschlossen an den AC-Anschluss AC1):

$$Z(DCP{-}{>}DCN,\ AC1)\ =\ Z\_DCP1\ +\ Z\_DCN3\ +\ Z\_DCN2\ +\ Z\_DCN1$$

- Für die zweite Wechselspannungsphase (angeschlossen an den AC-Anschluss AC2):

$$Z(DCP{-}{>}DCN,\ AC2)\ =\ Z\_DCP1\ +\ Z\_DCP2\ +\ Z\_DCN2\ +\ Z\_DCN1$$

- Für die dritte Wechselspannungsphase (angeschlossen an den AC-Anschluss AC3):

$$Z(DCP{-}{>}DCN,\ AC3)\ =\ Z\_DCP1\ +\ Z\_DCP2\ +\ Z\_DCP3\ +\ Z\_DCN1$$

wobei Z(DCP->DCN, AC1), Z(DCP->DCN, AC2) und Z(DCP->DCN, AC3) innerhalb der tolerierbaren Abweichung gleich sein sollen.

Weiterhin sind in diesem Beispiel die Impedanzen zwischen dem positiven DC-Anschluss DCP bzw. dem negativen DC-Anschluss DCN einerseits und den beiden mittleren DC-Anschlüssen DCM1 und DCM2 andererseits für die drei Phasen der Wechselspannung innerhalb der tolerierbaren Abweichung gleich, d.h. also wegen einer teilweisen Reihenschaltung und teilweisen Parallelschaltung der Einzel-Impedanzen (notiert mit "||", wobei sich der Kehrwert einer Gesamt-Impedanz bei einer Parallelschaltung von Einzelimpedanzen aus der Summe der Kehrwerte der Einzel-Impedanzen ergibt):

- Für die erste Wechselspannungsphase (angeschlossen an den AC-Anschluss AC1):

$$Z(DCP{-}{>}DCM1/DCM2,\ AC1)\ =\ Z\_DCP1\ +\ (Z\_DCM1\ ||\ (Z\_DCM2\ +$$
$$Z\_DCM3\ +\ Z\_DCM4))$$

$$Z(DCN{-}{>}\ DCM1/DCM2,\ AC1)\ =\ Z\_DCN1\ +\ Z\_DCN2\ +\ Z\_DCN3\ +$$
$$(Z\_DCM1\ ||\ (Z\_DCM2\ +\ Z\_DCM3\ +\ Z\_DCM4))$$

- Für die zweite Wechselspannungsphase (angeschlossen an den AC-Anschluss AC2):

$$Z(DCP{-}{>}DCM1/DCM2,\ AC2)\ =\ Z\_DCP1\ +\ Z\_DCP2\ +\ ((Z\_DCM2\ +$$
$$Z\_DCM1)\ ||\ (Z\_DCM3\ +\ Z\_DCM4))$$

$$Z(DCN{-}{>}\ DCM1/DCM2,\ AC2)\ =\ Z\_DCN1\ +\ Z\_DCN2\ +\ ((Z\_DCM2\ +$$
$$Z\_DCM1)\ ||\ (Z\_DCM3\ +\ Z\_DCM4))$$

- Für die dritte Wechselspannungsphase (angeschlossen an den AC-Anschluss AC3):

$$Z(DCP{\rightarrow}DCM1/DCM2, AC3) = Z\_DCP1 + Z\_DCP2 + Z\_DCP3 +$$
$$((Z\_DCM3 + Z\_DCM2 + Z\_DCM1) \;||\; Z\_DCM4)$$

$$Z(DCN{\rightarrow}\; DCM1/DCM2, AC3) = Z\_DCN1 + ((Z\_DCN3 + Z\_DCN2 +$$
$$Z\_DCN1) \;||\; Z\_DCM4)$$

wobei Z(DCP->DCM1/DCM2, AC1), Z(DCP->DCM1/DCM2, AC2) und Z(DCP->DCM1/DCM2, AC3) innerhalb der tolerierbaren Abweichung gleich sein sollen, wobei auch Z(DCN-> DCM1/DCM2, AC1), Z(DCN-> DCM1/DCM2, AC2) und Z(DCN-> DCM1/DCM2, AC3) innerhalb der tolerierbaren Abweichung gleich sein sollen und schließlich aus Symmetriegründen auch Z(DCP->DCM1/DCM2, AC1), Z(DCP->DCM1/DCM2, AC2) und Z(DCP->DCM1/DCM2, AC3) sowie Z(DCN-> DCM1/DCM2, AC1), Z(DCN-> DCM1/DCM2, AC2) und Z(DCN-> DCM1/DCM2, AC3) innerhalb der tolerierbaren Abweichung gleich sein sollen.

Sind die Halbleiter 4 als Transistoren T1, T2, ..., T9 ausgestaltet, so sind die genannten Impedanzen Z insbesondere bei der Schalt- bzw. Taktfrequenz der Transistoren T1, T2, ..., T9 innerhalb der tolerierbaren Abweichung gleich. In einigen Beispielen kann die entsprechende Induktivität zwischen den DC-Anschlüssen zweier der Gleichspannungen für die drei Phasen der Wechselspannung innerhalb der tolerierbaren Abweichung gleich sein.

Die Figur 3 zeigt ein erstes Ausführungsbeispiel des vorgeschlagenen Leistungsmoduls 5, wobei eine schematische Draufsicht dargestellt ist.

Das Leistungsmodul 5 weist ein Substrat 1 auf, welches Ähnlichkeiten mit dem Substrat 1 gemäß dem ersten Ausführungsbeispiel aufweist. Weiterhin weist das Leistungsmodul 5 ein Modulgehäuse 6 auf, welches das Substrat 1 teilweise einhaust. Ferner weist das Leistungsmodul 5 drei an den langen Seiten 2A, 2B angeordnete Modul-AC-Anschlüsse MAC1, MAC2, MAC3 auf, die mit den drei AC-Anschlüssen AC1, AC2, AC3 des Substrats 1 elektrisch verbunden sind. Dabei sind die drei Modul-AC-Anschlüsse MAC1, MAC2, MAC3 vorzugsweise an einer der beiden langen Seiten 2A, 2B angeordnet, bspw. wie in Figur 1 dargestellt an der ersten langen Seite 2A. Außerdem weist das Leistungsmodul vier an den kurzen Seiten 3A, 3B angeordnete Modul-DC-Anschlüsse MDCP, MDCM1, MDCM2, MDCN auf, die mit den vier DC-Anschlüssen DCP, DCM1, DCM2, DCN des Substrats 1 elektrisch verbunden sind.

Die Figur 4 zeigt ein zweites Ausführungsbeispiel des vorgeschlagenen Leistungsmoduls 5, wobei eine schematische Draufsicht dargestellt ist.

Das Leistungsmodul 5 weist ein Substrat 1 auf, welches Ähnlichkeiten mit dem Substrat 1 gemäß dem ersten Ausführungsbeispiel aufweist. Weiterhin weist das Leistungsmodul 5 ein Modulgehäuse 6 auf, welches das Substrat 1 teilweise einhaust. Dabei weist das Modulgehäuse 6 mehrere Ausnehmungen 7 auf, wobei in manche der Ausnehmungen 7 jeweils ein Anschlusspin 8 eingebracht ist. Vorteilhafterweise wird dabei in jene Ausnehmungen 7 ein jeweiliger Anschlusspin 8 eingebracht, welche in der Nähe der DC-Anschlüsse DCP, DCM1, DCM2, DCN oder der AC-Anschlüsse AC1, AC2, A3 des Substrats 1 angeordnet sind. Dabei sind drei der Anschlusspins 8 mit den drei AC-Anschlüssen AC1, AC2, AC3 des Substrats 1 elektrisch verbunden, und vier der Anschlusspins 8 sind mit den vier DC-Anschlüssen DCP, DCM1, DCM2, DCN des Substrats 1 elektrisch verbunden.

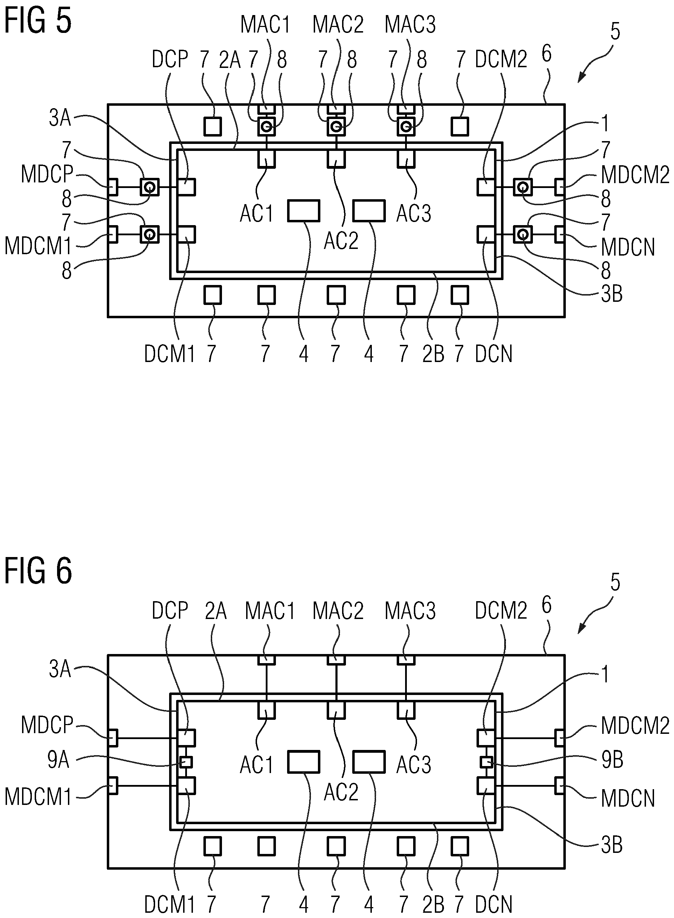

Die Figur 5 zeigt ein drittes Ausführungsbeispiel des vorgeschlagenen Leistungsmoduls 5, wobei wiederum eine schematische Draufsicht dargestellt ist.

Das Leistungsmodul 5 weist Ähnlichkeiten mit dem Leistungsmodul 5 gemäß dem zweiten Ausführungsbeispiel auf. Weiterhin weist das Leistungsmodul 5 drei an den langen Seiten 2A, 2B angeordnete Modul-AC-Anschlüsse MAC1, MAC2, MAC3 auf, die über die drei o.g. Anschlusspins 8 mit den drei AC-Anschlüssen AC1, AC2, AC3 des Substrats 1 elektrisch verbunden sind. Dabei sind die drei Modul-AC-Anschlüsse MAC1, MAC2, MAC3 vorzugsweise an einer der beiden langen Seiten 2A, 2B angeordnet, bspw. wie in Figur 1 dargestellt an der ersten langen Seite 2A. Weiterhin weist das Leistungsmodul vier an den kurzen Seiten 3A, 3B angeordnete Modul-DC-Anschlüsse MDCP, MDCM1, MDCM2, MDCN auf, die über die vier o.g. Anschlusspins 8 mit den vier DC-Anschlüssen DCP, DCM1, DCM2, DCN des Substrats 1 elektrisch verbunden sind.

Wie in Figur 5 dargestellt, sind dabei der mit dem positiven DC-Anschluss DCP elektrisch verbundene Modul-DC-Anschluss MDCP und der mit dem ersten mittleren DC-Anschluss DCM1 elektrisch verbundene Modul-DC-Anschluss MDCM1 an der ersten kurzen 3A Seite angeordnet, wobei der mit dem positiven DC-Anschluss DCP elektrisch verbundene Modul-DC-Anschluss MDCP näher an der ersten langen Seite 2A angeordnet ist als der mit dem ersten mittleren DC-Anschluss DCM1 elektrisch verbundene Modul-DC-Anschluss MDCM1. Weiterhin sind der mit dem negativen DC-Anschluss DCN elektrisch verbundene Modul-DC-Anschluss MDCN und der mit dem zweiten mittleren DC-Anschluss

DCM2 elektrisch verbundene Modul-DC-Anschluss MDCM2 an der zweiten kurzen Seite 3B angeordnet, wobei der mit dem negativen DC-Anschluss DCN elektrisch verbundene Modul-DC-Anschluss MDCN näher an der zweiten langen Seite 2B angeordnet ist als der mit dem zweiten mittleren DC-Anschluss DCM2 elektrisch verbundene Modul-DC-Anschluss MDCM2.

Die Figur 6 zeigt ein viertes Ausführungsbeispiel des vorgeschlagenen Leistungsmoduls 5, wobei wiederum eine schematische Draufsicht dargestellt ist.

Das Leistungsmodul 5 weist Ähnlichkeiten mit dem Leistungsmodul 5 gemäß dem ersten Ausführungsbeispiel auf. Weiterhin weist das Leistungsmodul 5 einen ersten Stützkondensator 9A und einen zweiten Stützkondensator 9B auf, welche beide auf dem Substrat 1 angeordnet sind. Dabei ist der erste Stützkondensator 9A zwischen die positive Gleichspannung am positiven DC-Anschluss DCP und die mittlere Gleichspannung am ersten mittleren DC-Anschluss DCM1 geschaltet. Der zweite Stützkondensator 9B ist zwischen die negative Gleichspannung am negativen DC-Anschluss DCN und die mittlere Gleichspannung am zweiten mittleren DC-Anschluss DCM2 geschaltet.

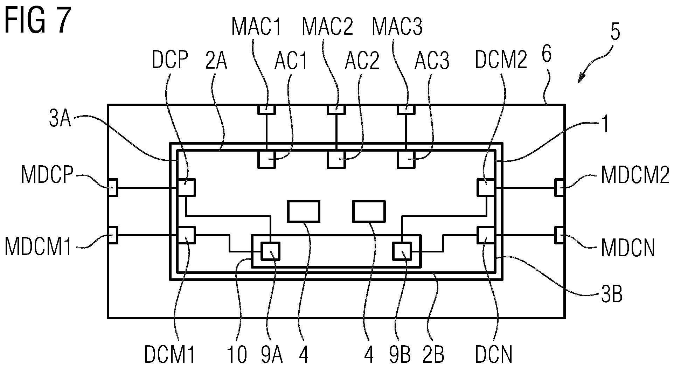

Die Figur 7 zeigt ein fünftes Ausführungsbeispiel des vorgeschlagenen Leistungsmoduls 5, wobei wiederum eine schematische Draufsicht dargestellt ist.

Das Leistungsmodul 5 weist Ähnlichkeiten mit dem Leistungsmodul 5 gemäß dem vierten Ausführungsbeispiel auf, wobei die Anordnung des ersten Stützkondensators 9A und des zweiten Stützkondensators 9B sich von dem vierten Ausführungsbeispiel unterscheidet. Das Leistungsmodul 5 weist nunmehr eine Leiterplatte 10 auf, auf welcher der erste Stützkondensator 9A und der zweite Stützkondensator 9B angeordnet sind, wobei der erste Stützkondensator 9A und der zweite Stützkondensator 9B weiterhin wie oben bereits erläutert passend mit den genannten DC-Anschlüssen DCP, DCM1, DCM2, DCN elektrisch verbunden sind.

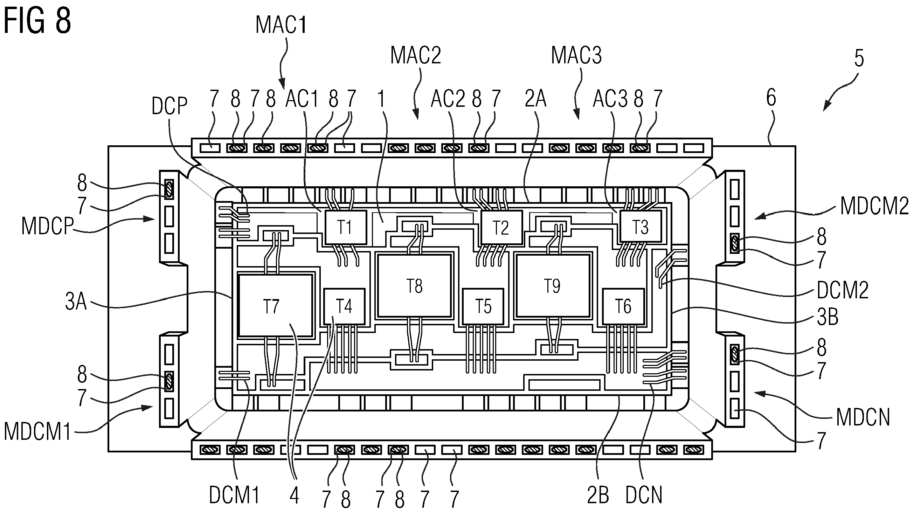

Die Figur 8 zeigt ein sechstes Ausführungsbeispiel des vorgeschlagenen Leistungsmoduls 5, wobei eine realistischere Darstellung in einer Draufsicht dargestellt ist.

Das Leistungsmodul 5 weist dabei große Ähnlichkeiten mit dem Leistungsmodul 5 gemäß dem dritten Ausführungsbeispiel auf.

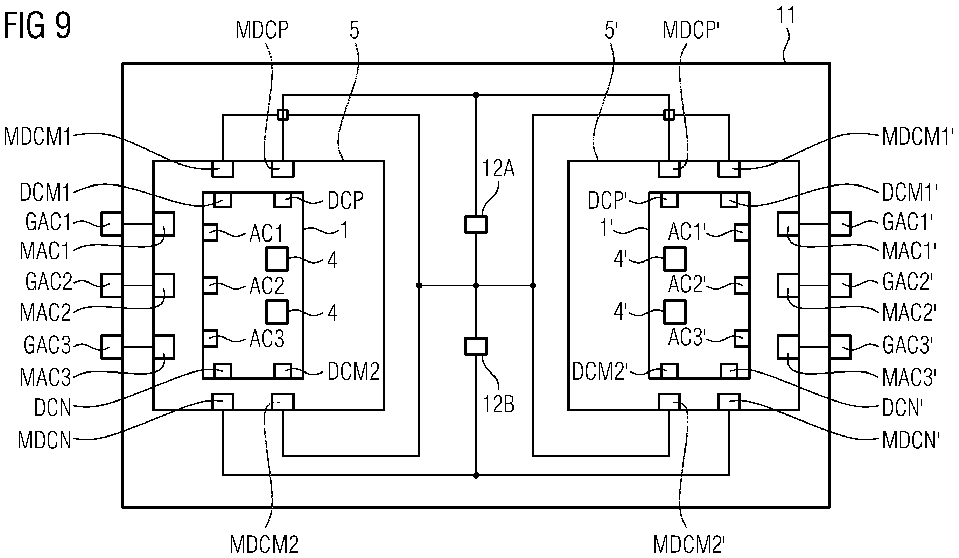

Die Figur 9 zeigt ein Ausführungsbeispiel des vorgeschlagenen elektrisches Geräts 11, wobei eine schematische Draufsicht dargestellt ist.

Bei dem dargestellten elektrischen Gerät 11 handelt es sich um einen Umrichter, der eine dreiphasige Wechselspannung, welche über die Geräte-AC-Anschlüsse GAC1, GAC2, GAC3 zuführbar ist, in eine andere dreiphasige Wechselspannung, welche über die Geräte-AC-Anschlüsse GAC1', GAC2', GAC3' abgreifbar ist, wandeln kann. Dazu weist das elektrische Gerät 11 zwei Leistungsmodule 5 und 5' auf, welche jeweils beispielsweise gemäß dem oben erläuterten zweiten Ausführungsbeispiel eines Leistungsmoduls ausgeführt sein können. Aus Gründen der Übersichtlichkeit werden einige Details der beiden Leistungsmodule 5 und 5' in der Figur 9 lediglich angedeutet und nicht genauer dargestellt.

Die Geräte-AC-Anschlüsse GAC1, GAC2, GAC3 sind dabei elektrisch mit den Modul-AC-Anschlüssen MAC1, MAC2, MAC3 des ersten Leistungsmoduls 5 verbunden, und die Geräte-AC-Anschlüsse GAC1', GAC2', GAC3' sind elektrisch mit den Modul-AC-Anschlüssen MAC1', MAC2', MAC3' des zweiten Leistungsmoduls 5' verbunden.

Das elektrische Gerät 11 weist weiterhin einen ersten Zwischenkreiskondensator 12A auf, welcher einerseits mit den Modul-DC-Anschlüssen MDCP, MDCP' für die positive Gleichspannung der beiden Leistungsmodule 5 und 5' verbunden ist. Andererseits ist der erste Zwischenkreiskondensator 12A mit den Modul-DC-Anschlüssen MDCM1, MDCM2, MDCM1', MDCM2' für die mittlere/neutrale Gleichspannung der beiden Leistungsmodule 5 und 5' verbunden.

Zusätzlich weist das elektrische Gerät 11 einen zweiten Zwischenkreiskondensator 12B auf, welcher einerseits mit den Modul-DC-Anschlüssen MDCN, MDCN' für die negative Gleichspannung der beiden Leistungsmodule 5 und 5' verbunden ist. Andererseits ist der zweite Zwischenkreiskondensator 12B mit den Modul-DC-Anschlüssen MDCM1, MDCM2, MDCM1', MDCM2' für die mittlere/neutrale Gleichspannung der beiden Leistungsmodule 5 und 5' verbunden.

Bei einigen abgewandelten Beispielen kann das elektrische Gerät 11 auch als Gleichrichter zum Gleichrichten einer dreiphasigen Wechselspannung in die drei Gleichspannungen ausgestaltet sein, wofür auf das zweite (in der Figur 9: rechte) Leistungsmodul 5' und die Geräte-AC-Anschlüsse GAC1', GAC2', GAC3' verzichtet wird. In anderen abgewandelten Beispielen kann das elektrische Gerät 11 auch als Wechselrichter zum Wechselrichten der drei Gleichspannungen in eine dreiphasige Wechselspannung ausgestaltet sein, wofür auf das erste (in der Figur 9: linke) Leistungsmodul 5' und die Geräte-AC-Anschlüsse GAC1, GAC2, GAC3 verzichtet wird.

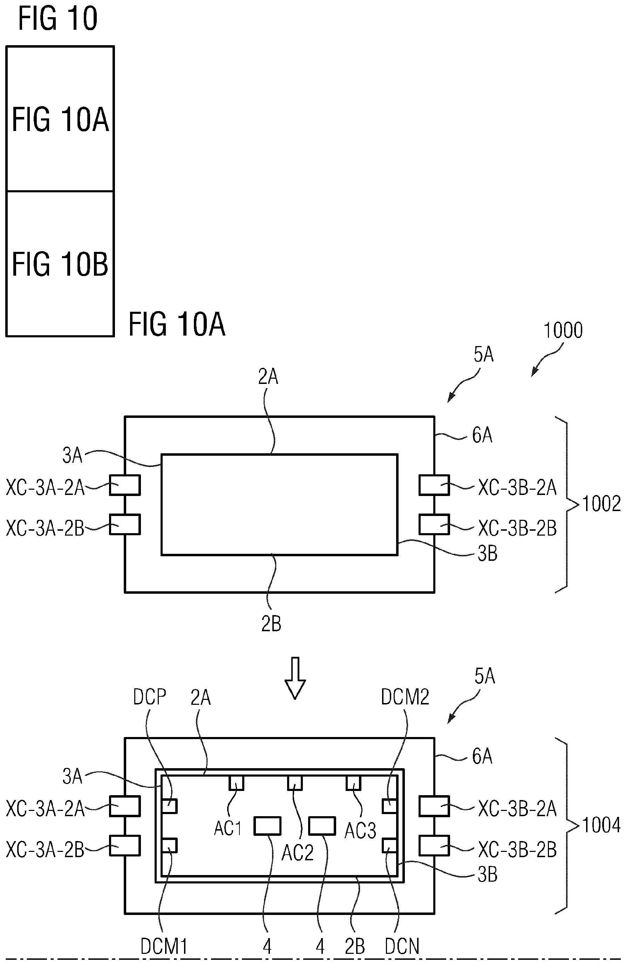

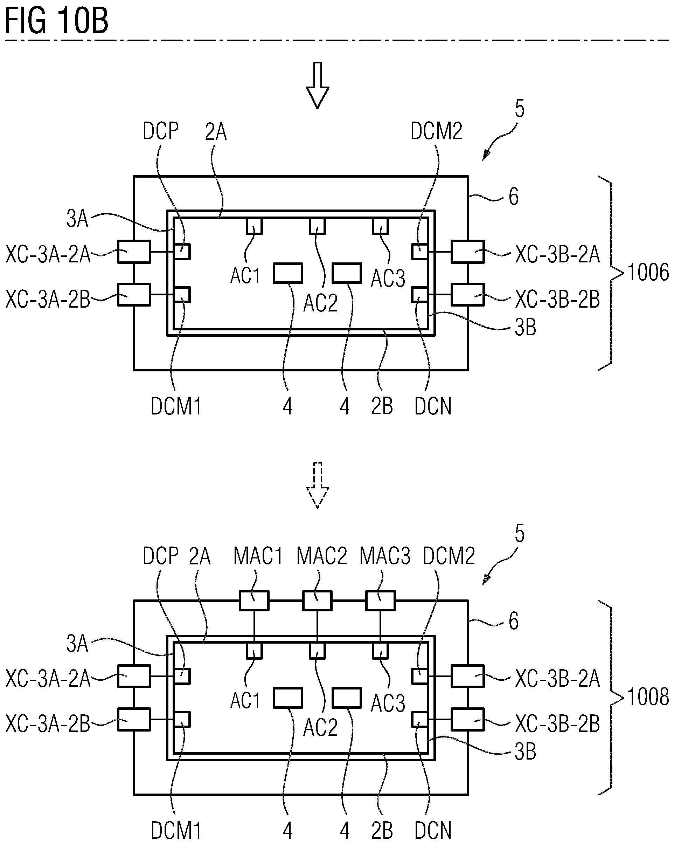

Die Figur 10 zeigt ein Ausführungsbeispiel des vorgeschlagenen Verfahrens 1000 zur Herstellung eines Ausführungsbeispiels eines Leistungsmoduls 5. Das Verfahren umfasst dabei folgende Verfahrensschritte.

In einem Verfahrensschritt 1002 wird ein Ausgangs-Leistungsmoduls 5A bereitgestellt, welches zwei, an der ersten kurzen Seite 3A angeordnete Ausgangs-Leistungsmodul-Spannungsanschlüsse XC-3A-2A, XC-3A-2B aufweist. Weiterhin weist das Ausgangs-Leistungsmodul 5A zwei, an der zweiten kurzen Seite 3B angeordnete Ausgangs-Leistungsmodul-Spannungsanschlüsse XC-3B-2A, XC-3B-2B auf. Darüber hinaus weist das Ausgangs-Leistungsmodul 5A ein Ausgangs-Modulgehäuse 6A zur Aufnahme und zum zumindest teilweisen Einhausen des Substrats 1 auf.

In einem Verfahrensschritt 1004 wird das Substrat 1 in das Ausgangs-Leistungsmodul 5A eingebracht.

In einem Verfahrensschritt 1006 wird eine jeweilige elektrische Verbindung von den vier DC-Anschlüssen DCP, DCM1, DCM2, DCN des Substrats 1 mit den vier Ausgangs-Leistungsmodul-Spannungsanschlüssen XC-3A-2A, XC-3A-2B, XC-3B-2A, XC-3B-2B hergestellt.

Dabei werden der positive DC-Anschluss DCP und der erste mittlere DC-Anschluss DCM1 mit den beiden, an der ersten kurzen Seite 3A angeordneten Ausgangs-Leistungsmodul-Spannungsanschlüssen XC-3A-2A, XC-3A-2B elektrisch verbunden, wobei der mit dem positiven DC-Anschluss DCP elektrisch verbundene Ausgangs-Leistungsmodul-Spannungsanschluss XC-3A-2A näher an der ersten langen Seite 2A angeordnet ist als der mit dem ersten mittleren DC-Anschluss DCM1 elektrisch verbundene Ausgangs-Leistungsmodul-Spannungsanschluss XC-3A-2B. Ferner werden der negative DC-Anschluss DCN und der zweite mittlere DC-Anschluss DCM2 mit den beiden, an der zweiten kurzen Seite 3B angeordneten Ausgangs-Leistungsmodul-Spannungsanschlüssen XC-3B-2A, XC-3B-2B elektrisch verbunden, wobei der mit dem negativen DC-Anschluss DCN elektrisch verbundene Ausgangs-Leistungsmodul-Spannungsanschluss XC-3B-2B näher an der zweiten langen Seite 2B angeordnet ist als der mit dem zweiten mittleren DC-Anschluss DCM2 elektrisch verbundene Ausgangs-Leistungsmodul-Spannungsanschluss XC-3B-2A.

In einem optionalen Verfahrensschritt 1008 (angedeutet mit dem gestrichelten Pfeil) werden drei, an den langen Seiten 2A, 2B des Ausgangs-Leistungsmoduls 5A angeordnete Modul-AC-Anschlüsse MAC1, MAC2, MAC3 bereitgestellt und eine jeweilige elektrische Verbindung von drei AC-Anschlüssen AC1, AC2, AC3 des Substrats 1 mit den drei Modul-AC-Anschlüssen MAC1, MAC2, MAC3 hergestellt.

## Patentansprüche

1.  Substrat (1) für ein Leistungsmodul,

    wobei das Substrat (1) bei einer Draufsicht im Wesentlichen rechteckig mit zwei, sich gegenüberliegenden langen Seiten (2A, 2B) und zwei, sich gegenüberliegenden kurzen Seiten (3A, 3B) ausgestaltet ist, und
    wobei das Substrat (1) mehrere Halbleiter (4) zur Wandlung einer dreiphasigen Wechselspannung (AC) in eine positive, eine mittlere und eine negative Gleichspannung (DC) bzw. zur Wandlung einer positiven, einer mittleren und einer negativen Gleichspannung (DC) in eine dreiphasige Wechselspannung (AC) aufweist,
    **gekennzeichnet durch**

    - drei an den langen Seiten (2A, 2B) angeordnete AC-Anschlüsse (AC1, AC2, AC3),
    - einen an der ersten kurzen Seite (3A) angeordneten positiven DC-Anschluss (DCP),
    - einen an der ersten kurzen Seite (3A) angeordneten ersten mittleren DC-Anschluss (DCM1),
    - einen an der zweiten kurzen Seite (3B) angeordneten zweiten mittleren DC-Anschluss (DCM2) und
    - einen an der zweiten kurzen Seite (3B) angeordneten negativen DC-Anschluss (DCN),

    wobei der positive DC-Anschluss (DCP) näher an der ersten langen Seite (2A) angeordnet ist als der erste mittlere DC-Anschluss (DCM1), und
    wobei der negative DC-Anschluss (DCN) näher an der zweiten langen Seite (2B) angeordnet ist als der zweite mittlere DC-Anschluss (DCM2).

2.  Substrat (1) nach Anspruch 1,
    wobei die drei AC-Anschlüsse (AC1, AC2, AC3) an einer der beiden langen Seiten (2A, 2B) angeordnet sind, vorzugsweise an der ersten langen Seite (2A).

3.  Substrat (1) nach einem der vorhergehenden Ansprüche, wobei das Substrat (1) derart ausgestaltet ist, dass die Impedanzen (Z) zwischen den DC-Anschlüssen (DCP, DCM1, DCM2, DCN) zweier der Gleichspannungen für die drei Phasen der Wechselspannung innerhalb einer tolerierbaren Abweichung gleich sind, wobei die tolerierbare Abweichung 25%, insbesondere 15% oder 10%, beträgt.

4.  Substrat (1) nach Anspruch 3,
    wobei das Substrat (1) derart ausgestaltet ist, dass die Impedanzen (Z) zwischen dem positiven DC-Anschluss (DCP) und den beiden mittleren DC-Anschlüssen (DCM1, DCM2) für die drei Phasen der Wechselspannung innerhalb der tolerierbaren Abweichung gleich sind und weiterhin innerhalb der tolerierbaren Abweichung gleich den Impedanzen (Z) zwischen dem negativen DC-Anschluss (DCN) und den beiden mittleren DC-Anschlüssen (DCM1, DCM2) für die drei Phasen der Wechselspannung sind.

5.  Leistungsmodul (5) aufweisend:

- ein Substrat (1) nach einem der vorhergehenden Ansprüche,
- ein Modulgehäuse (6), welches das Substrat (1) zumindest teilweise einhaust.

**6.** Leistungsmodul (5) nach Anspruch 5, weiterhin aufweisend:

- drei an den langen Seiten (2A, 2B) angeordnete Modul-AC-Anschlüsse (MAC1, MAC2, MAC3), die mit den drei AC-Anschlüssen (AC1, AC2, AC3) des Substrats (1) elektrisch verbunden sind, und
- vier an den kurzen Seiten (3A, 3B) angeordnete Modul-DC-Anschlüsse (MDCP, MDCM1, MDCM2, MDCN), die mit den vier DC-Anschlüssen (DCP, DCM1, DCM2, DCN) des Substrats (1) elektrisch verbunden sind.

**7.** Leistungsmodul (5) nach Anspruch 6,

wobei der mit dem positiven DC-Anschluss (DCP) elektrisch verbundene Modul-DC-Anschluss (MDCP) und der mit dem ersten mittleren DC-Anschluss (DCM1) elektrisch verbundene Modul-DC-Anschluss (MDCM1) an der ersten kurzen (3A) Seite angeordnet sind,
wobei der mit dem positiven DC-Anschluss (DCP) elektrisch verbundene Modul-DC-Anschluss (MDCP) näher an der ersten langen Seite (2A) angeordnet ist als der mit dem ersten mittleren DC-Anschluss (DCM1) elektrisch verbundene Modul-DC-Anschluss (MDCM1),
wobei der mit dem negativen DC-Anschluss (DCN) elektrisch verbundene Modul-DC-Anschluss (MDCN) und der mit dem zweiten mittleren DC-Anschluss (DCM2) elektrisch verbundene Modul-DC-Anschluss (MDCM2) an der zweiten kurzen Seite (3B) angeordnet sind, und
wobei der mit dem negativen DC-Anschluss (DCN) elektrisch verbundene Modul-DC-Anschluss (MDCN) näher an der zweiten langen Seite (2B) angeordnet ist als der mit dem zweiten mittleren DC-Anschluss (DCM2) elektrisch verbundene Modul-DC-Anschluss (MDCM2).

**8.** Leistungsmodul (5) nach einem der Ansprüche 5 bis 7, weiterhin aufweisend:

- einen ersten Stützkondensator (9A), welcher zwischen die positive Gleichspannung am positiven DC-Anschluss (DCP) und die mittlere Gleichspannung am ersten mittleren DC-Anschluss (DCM1) geschaltet ist, und
- einen zweiten Stützkondensator (9B), welcher zwischen die negative Gleichspannung am negativen DC-Anschluss (DCN) und die mittlere Gleichspannung am zweiten mittleren DC-Anschluss (DCM2) geschaltet ist.

**9.** Leistungsmodul (5) nach Anspruch 8,

weiterhin aufweisend eine Leiterplatte (10),
wobei der erste Stützkondensator (9A) und der zweite Stützkondensator (9B) jeweils auf der Leiterplatte (10) angeordnet sind.

**10.** Leistungsmodul (5) nach Anspruch 8,
wobei der erste Stützkondensator (9A) und der zweite Stützkondensator (9B) jeweils auf dem Substrat (1) angeordnet sind.

**11.** Leistungsmodul (5) nach einem der Ansprüche 5 bis 10,

wobei das Leistungsmodul (10) mit einer elektrischen Leistung von zumindest mehreren 10 kW, vorzugsweise 40 kW bis 500 kW, mit einer Wechselspannung von zumindest mehreren 100 V, vorzugsweise 280 V bis 800 V, mit einer Gleichspannung von zumindest mehreren 100 V, vorzugsweise 800 V bis 1500 V, und/oder elektrischen Strömen von mehreren 10 A, vorzugsweise 70 A bis 1000 A, betreibbar ist.

**12.** Elektrisches Gerät (11), insbesondere Umrichter, aufweisend:

- zumindest ein Leistungsmodul (5), vorzugsweise zumindest zwei Leistungsmodule (5), nach einem der Ansprüche 5 bis 11,
- zumindest einen ersten Zwischenkreiskondensator (12A), welcher zwischen den mit dem positiven DC-Anschluss (DCP) elektrisch verbundenen Modul-DC-Anschluss (MDCP) einerseits und die mit den mittleren DC-Anschlüssen (DCM1, DCM2) elektrisch verbundenen Modul-DC-Anschlüsse (MDCM1, MDCM2) andererseits geschaltet ist, und
- zumindest einen zweiten Zwischenkreiskondensator (12B), welcher zwischen den mit dem negativen DC-Anschluss (DCN) elektrisch verbundenen Modul-DC-Anschluss (MDCN) einerseits und die mit den mittleren DC-Anschlüssen (DCM1, DCM2) elektrisch verbundenen Modul-DC-Anschlüsse (MDCM1, MDCM2) andererseits geschaltet ist.

**13.** Verfahren zur Herstellung eines Leistungsmoduls (5) nach einem der Ansprüche 5 bis 11 umfassend die Verfahrensschritte:

    - Bereitstellen eines Ausgangs-Leistungsmoduls (5A) aufweisend:

        o zumindest zwei, an der ersten kurzen Seite (3A) angeordnete Ausgangs-Leistungsmodul-Spannungsanschlüsse (XC-3A-2A, XC-3A-2B),
        o zumindest zwei, an der zweiten kurzen Seite (3B) angeordnete Ausgangs-Leistungsmodul-Spannungsanschlüsse (XC-3B-2A, XC-3B-2B),
        o ein Ausgangs-Modulgehäuse (6A) zur Aufnahme und zum zumindest teilweisen Einhausen des Substrats (1), und

    - Einbringen des Substrats (1) in das Ausgangs-Leistungsmodul (5A),
    - Herstellen einer jeweiligen elektrischen Verbindung von den vier DC-Anschlüssen (DCP, DCM1, DCM2, DCN) des Substrats (1) mit den vier Ausgangs-Leistungsmodul-Spannungsanschlüssen (XC-3A-2A, XC-3A-2B, XC-3B-2A, XC-3B-2B) .

**14.** Verfahren nach Anspruch 13,

    wobei der positive DC-Anschluss (DCP) und der erste mittlere DC-Anschluss (DCM1) mit den beiden, an der ersten kurzen Seite (3A) angeordneten Ausgangs-Leistungsmodul-Spannungsanschlüssen (XC-3A-2A, XC-3A-2B) elektrisch verbunden werden,
    wobei der mit dem positiven DC-Anschluss (DCP) elektrisch verbundene Ausgangs-Leistungsmodul-Spannungsanschluss (XC-3A-2A) näher an der ersten langen Seite (2A) angeordnet ist als der mit dem ersten mittleren DC-Anschluss (DCM1) elektrisch verbundene Ausgangs-Leistungsmodul-Spannungsanschluss (XC-3A-2B),
    wobei der negative DC-Anschluss (DCN) und der zweite mittlere DC-Anschluss (DCM2) mit den beiden, an der zweiten kurzen Seite (3B) angeordneten Ausgangs-Leistungsmodul-Spannungsanschlüssen (XC-3B-2A, XC-3B-2B) elektrisch verbunden werden, und
    wobei der mit dem negativen DC-Anschluss (DCN) elektrisch verbundene Ausgangs-Leistungsmodul-Spannungsanschluss (XC-3B-2B) näher an der zweiten langen Seite (2B) angeordnet ist als der mit dem zweiten mittleren DC-Anschluss (DCM2) elektrisch verbundene Ausgangs-Leistungsmodul-Spannungsanschluss (XC-3B-2A) .

**15.** Verfahren nach Anspruch 13 oder 14, weiterhin umfassend die folgenden Verfahrensschritte:

    - Bereitstellen von drei, an den langen Seiten (2A, 2B) des Ausgangs-Leistungsmoduls (5A) angeordneten Modul-AC-Anschlüssen (MAC1, MAC2, MAC3), und
    - Herstellen einer jeweiligen elektrischen Verbindung von den drei AC-Anschlüssen (AC1, AC2, AC3) des Substrats (1) mit den drei Modul-AC-Anschlüssen (MAC1, MAC2, MAC3).

FIG 1

AC1  AC2  AC3

2A

3A
DCP

DCM2

DCM1

DCN
3B

1

4  4  2B

FIG 2

1
2A

Z_DCP1  Z_DCP2  Z_DCP3

DCP

3A

3B

9A

T1  4  T2  4  T3  4

T7  T8  T9

4  AC1  4  AC2  4  AC3

DCM2

DCM1

9B

Z_DCM1  Z_DCM2  Z_DCM3  Z_DCM4

T4  4  T5  4  T6  4

2B

Z_DCN3  Z_DCN2  Z_DCN1  DCN

FIG 3

DCP  2A  MAC1  MAC2  MAC3  DCM2  6  5

3A  MDCP  MDCM1

AC1  AC2  AC3

1  MDCM2  MDCN  3B

DCM1  4  4  2B  DCN

FIG 4

DCP  7  2A  7  8  7  8  7  8  7  DCM2  6  5

3A  7  8  7  8

AC1  AC2  AC3

1  7  8  7  8  3B

DCM1  7  7  4  7  4  7  2B  7  DCN

FIG 5

FIG 6

FIG 7

FIG 8

EP 4 346 343 A1

FIG 9

## FIG 10

| FIG 10A |
|---------|
| FIG 10B |

### FIG 10A

# FIG 10B

Europäisches
Patentamt

European
Patent Office

Office européen
des brevets

**EUROPÄISCHER RECHERCHENBERICHT**

**Nummer der Anmeldung**

**EP 22 19 8412**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2013 008193 A1 (AUDI AG [DE]; FRAUNHOFER GES FORSCHUNG [DE]; VOLKSWAGEN AG [DE]) 20. November 2014 (2014-11-20) * Absätze [0008] – [0012]; Abbildungen 1,4-5 * * Absatz [0043]; Abbildung 6 * ----- | 1-15 | INV. H05K5/02 H05K7/14 H05K5/00 |
| X | DE 44 18 426 A1 (MITSUBISHI ELECTRIC CORP [JP]) 30. November 1995 (1995-11-30) * Zeilen 35-64, Absatz 15; Abbildungen 13-16 * * Spalte 21, Zeile 47 – Spalte 22, Zeile 41 * ----- | 1-15 | |

**RECHERCHIERTE SACHGEBIETE (IPC)**

H05K

Der vorliegende Recherchenbericht wurde für alle Patentansprüche erstellt

| Recherchenort | Abschlußdatum der Recherche | Prüfer |
|---|---|---|
| Den Haag | 2. März 2023 | Shaalan, Mohamed |

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 22 19 8412

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

02-03-2023

| Im Recherchenbericht angeführtes Patentdokument | Datum der Veröffentlichung | Mitglied(er) der Patentfamilie | Datum der Veröffentlichung |
|---|---|---|---|
| DE 102013008193 A1 | 20-11-2014 | CN 105210464 A | 30-12-2015 |
| | | DE 102013008193 A1 | 20-11-2014 |
| | | EP 2997801 A1 | 23-03-2016 |
| | | US 2016094150 A1 | 31-03-2016 |
| | | WO 2014184030 A1 | 20-11-2014 |
| DE 4418426 A1 | 30-11-1995 | DE 4418426 A1 | 30-11-1995 |
| | | US 5747875 A | 05-05-1998 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 8847328 B1